# FASCICULE DE BREVET EUROPEEN

(11) **EP 1 738 303 B1**
(45) Date de publication et mention de la délivrance du brevet: **17.09.2008**
(21) Numéro de dépôt: 04723271.5
(22) Date de dépôt: 25.03.2004
(51) Int. Cl.: G06K 19/077, H01F 41/06

(54) **PROCEDE DE FABRICATION D'UNE ETIQUETTE ELECTRONIQUE**
VERFAHREN ZUR HERSTELLUNG EINES ELEKTRONISCHEN LABELS
METHOD FOR MAKING AN ELECTRONIC LABEL

(43) Date de publication de la demande: 03.01.2007
(73) Titulaire: Bauer, Eric, 6052 Hergiswil (CH)
(72) Inventeur: BAUER, Pierre, Alain, CH-2206 Les Geneveys-Sur-Coffrane (CH)
(74) Mandataire: Micheli & Cie SA
(86) Numéro de dépôt international: PCT/IB2004/000887
(87) Numéro de publication internationale: WO 2005/093645

(56) Documents cités:
- EP-A- 0 913 268
- EP-A- 1 471 544
- DE-A- 4 205 742
- US-A- 4 110 838

## Description

La présente invention a pour objet un procédé de fabrication d'une étiquette électronique ainsi qu'une étiquette électronique obtenue par la mise en oeuvre du procédé de fabrication. Un autre objet de l'invention concerne une électrode de soudage permettant de mettre en oeuvre le procédé de fabrication d'une étiquette électronique selon l'invention. Plus particulièrement, l'invention concerne les étapes d'un procédé de fabrication permettant de produire une étiquette électronique composée principalement d'un support fibreux tel que du papier et/ou du textile par exemple ou un support en matière plastique, accueillant une puce électronique munie de deux plages de contact ainsi qu'une antenne constituée d'un fil conducteur.

Les étiquettes électroniques sont des dispositifs passifs ou éventuellement actifs qui peuvent échanger des données avec un lecteur adéquat muni également d'une antenne. Dans le cas d'un dispositif passif, l'échange de données entre le lecteur et l'étiquette électronique se fait par couplage électromagnétique. Le champ radiant émis par l'antenne du lecteur permet de fournir l'énergie nécessaire au fonctionnement de la puce électronique comprise dans l'étiquette lorsque cette dernière se trouve à proximité du lecteur.

De nombreuses applications sont susceptibles d'utiliser cette technique, on citera à titre d'exemple non limitatif la gestion d'un stock d'articles munis de telles étiquettes ou l'identification d'objets porteurs d'étiquettes électroniques. Ces étiquettes électroniques sont appelées à remplacer avantageusement les codes barre ou d'autres identifiant marquant les objets les plus divers afin d'optimiser la gestion de stock qui devient alors automatique ou d'optimiser tout autre traitement de données fournies par ces articles.

Une des difficultés rencontrées dans la fabrication de telles étiquettes réside notamment dans la fixation de l'antenne sur les plages de contact de la puce électronique intégrée dans l'étiquette. En effet cette opération est rendue difficile par la très petite taille des puces électroniques utilisées dans de telles étiquettes.

Des techniques connues utilisent par exemple la fixation avec une colle conductrice des extrémités de l'antenne sur chacune des deux plages de contact de la puce électronique. D'autres techniques consistent à intégrer, par sérigraphie, l'antenne dans une feuille plastique et de laminer ensuite cette feuille sur le support de l'étiquette accueillant la puce électronique. Ces techniques connues présentent certains inconvénients parmi lesquels on peut citer, dans le cas de l'utilisation de colles conductrices, le fait que la colle doive être appliquée de façon très précise sur des surfaces très petites. De ce fait, on ne peut éviter que la colle ne coule et provoque un court-circuit, rendant ainsi l'étiquette inutilisable.

Les techniques de laminage sont quant à elles difficiles et coûteuses à mettre en oeuvre.

La présente invention à pour but de proposer un procédé de fabrication d'une ou de plusieurs étiquettes électroniques qui soit simple à mettre en oeuvre et qui permette de produire plus rapidement et plus avantageusement des étiquettes électroniques.

Ce but est atteint par un procédé de fabrication qui se distingue par les caractéristiques énoncées à la revendication 1. La revendication 1 a été délimitée par rapport à EP-A-0 913 268.

Les buts, objets et caractéristiques de l'invention ressortiront mieux à la lecture de la description qui suit et qui fait référence aux dessins annexés dans lesquels :
La figure 1 illustre un chip électronique pour la réalisation d'une étiquette selon l'invention.
La figure 2 montre l'opération d'étirage d'un fil conducteur en vue de sa connexion sur le chip électronique.
La figure 3 illustre en particulier l'électrode de soudage avant l'opération de soudage permettant la mise en oeuvre du procédé selon l'invention.
La figure 4 illustre le chip électronique durant l'opération de soudage du fil conducteur formant antenne.
La figure 5 illustre de façon schématique une variante de fabrication d'une étiquette électronique selon l'invention utilisant deux segments de fils conducteur pour réaliser l'antenne.

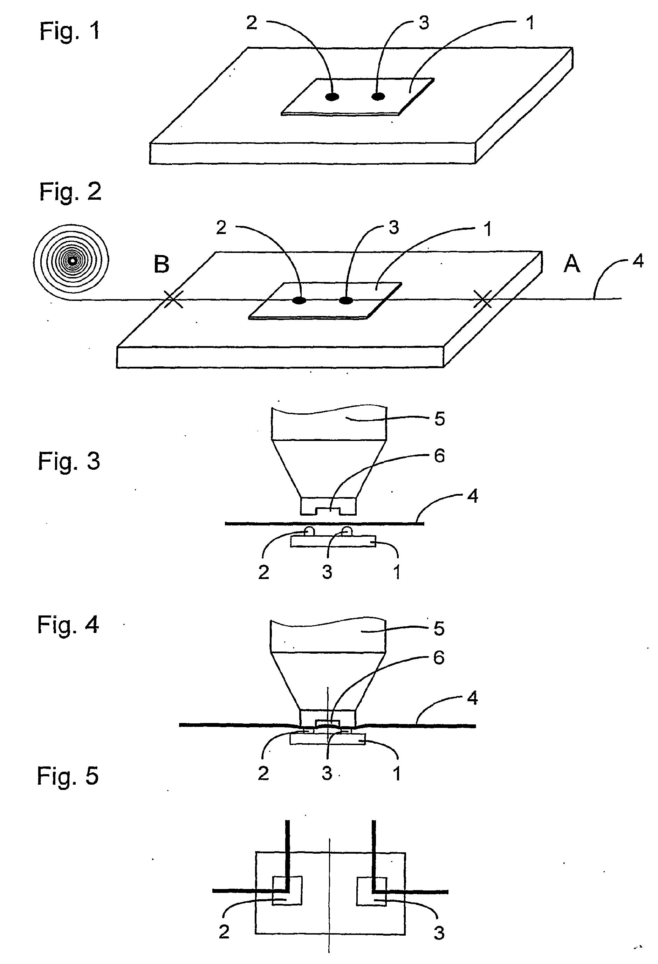

Référence est faite à la figure 1 qui illustre schématiquement une puce électronique 1 munie de deux plages de contact 2, 3. Les plages de contact (2,3) sont par exemple constituées d'une protubérance en or ou en étain, généralement appelé 'gold bumper' ou 'solder bumber' selon la terminologie anglaise consacrée. Les chips ou puces électroniques 1 utilisés pour la réalisation d'étiquettes électroniques selon l'invention peuvent être des puces UHF passives, c'est-à-dire dépourvues de source d'énergie et qui sont alimentées par couplage électromagnétique grâce à un lecteur (non représenté) muni d'une antenne. La tension induite dans l'antenne de l'étiquette est rectifiée et sert à alimenter le chip. Typiquement les chips passifs disponibles sur le marché permettent de travailler à une distance d'environ 4 mètres et peuvent traiter environ 100 dispositifs par seconde.

Un exemple de chips passifs pouvant être utilisés pour la réalisation d'étiquettes électroniques selon l'invention sont ceux distribués sous la référence EM4222 de la société EM Microelectronic - Marin S.A.

Les dimensions de tels chips sont de l'ordre de 700 microns x 900 microns et la distance entre les plages de contact 2 et 3 est de l'ordre de 400 microns. Le diamètre des plages de contact est de l'ordre de 80 microns.

Bien entendu, le procédé de fabrication objet de l'invention peut sans autre être appliqué à la réalisation d'étiquettes électroniques utilisant d'autres chips électroniques comme des chips actifs ou des chips à hautes fréquences par exemple, dès lors qu'il y a lieu de connecter un conducteur formant antenne sur les plages de contact du chip.

Dans la description qui suit, les étapes de fabrication sont décrites dans le cadre d'une fabrication manuelle d'une étiquette électronique. Il est évident que toutes ces étapes peuvent être automatisées partiellement ou complètement par des moyens connus qui sortent du cadre de la présente demande et qui en conséquence ne seront pas décrits en détail.

A la figure 1, on a représenté schématiquement un chip 1 adapté à la réalisation d'une étiquette électronique disposé sur un posage plane. La face inférieure du chip 1 ne comportant pas de plages de contact est en contact avec la face supérieure du posage.

Pour réaliser l'étiquette électronique, il est nécessaire de connecter une antenne dipôle ouverte sur les plages de contact 2, 3 du chip 1. L'antenne est constituée d'un fil conducteur 4, par exemple un fil de cuivre, dont le diamètre est compris entre 50 et 100 microns.

A la figure 2, un fil conducteur 4 est dévidé d'une bobine et amené en regard des deux plages de contact 2, 3 du chip 1. Une fois que le fil 4 a atteint la longueur souhaitée pour former l'antenne, il est coupé à ses deux extrémités A et B.

La prochaine étape du procédé de fabrication consiste à souder le fil conducteur 4 sur les deux plages de contact 2, 3. Ceci est réalisé grâce à une électrode de soudage 5 dont la partie active présente une extrémité munie d'un évidement 6 dans sa partie centrale. La largeur de l'évidement 6 correspond sensiblement à la distance séparant les deux plages de contact 2, 3 et sa profondeur correspond au minimum à la hauteur des plages de contact 2, 3. A titre d'exemple, une telle électrode ou tête de soudage est représentée schématiquement à la figure 3 lorsqu'elle est positionnée à l'instant qui précède l'opération de soudage.

A la figure 4, la tête de soudage est pressée contre le fil conducteur. Sous l'effet de la chaleur et de la pression, le fil 4 est soudé en une seule opération sur les deux plages de contact 2, 3. La partie de fil conducteur 4 située entre les deux plages de contact 2, 3 va se déformer sous l'effet de la chaleur. De plus la pression exercée par la tête de soudure 5 sur le fil 4 aura tendance à accentuer cette déformation en augmentant la matière entre les deux plages de contact 2, 3. Des essais ont montré que le fil conducteur 4 se déforme légèrement et forme un arc de cercle dirigé vers l'évidement 6 de l'électrode de soudage.

L'étape suivante consiste à couper le fil conducteur entre les deux plages de connexion 2, 3 à l'aide d'un outil de coupe approprié de manière à éliminer le court-circuit formé durant la soudure du fil 4 sur les plages de contact 2, 3.

On notera que l'opération de soudure, grâce à la forme de l'électrode 5 comportant un évidement 6, permet de souder le fil 4 sur les deux plages de contact 2, 3 en une seule opération ce qui est avantageux en terme de rapidité d'exécution. En effet, dans d'autres procédés, chaque extrémité du fil conducteur est soudée séparément ce qui nécessite deux opérations de soudage distinctes avec la perte de temps qui en découle. Grâce à la configuration particulière de la tête de soudage, en particulier la présence de l'évidement 6 dans sa partie centrale, on obtient une déformation du fil conducteur 4 après l'opération de soudure qui facilite l'opération de coupe. En effet, la portion de fil 4 située entre les plages de contact 2, 3 présente une configuration en arc de cercle dirigé vers l'extérieur ce qui diminue le risque d'endommager le chip lors de l'opération de coupe du fil.

Dans une variante du procédé, illustrée partiellement à la figure 5, le fil 4 est préalablement coupé à la bonne longueur et au moins une partie de chacun des deux segments de fil 4 est amenée en regard de l'une des deux plages de contact 2, 3. Dans cette variante, l'opération de soudure est également unique et permet de former l'antenne en une seule opération au cours de laquelle les deux segments du fil conducteur 4 sont soudées sur les plages 2, 3 à l'aide de l'électrode de soudage 5.

La dernière étape pour réaliser l'étiquette électronique consiste à envelopper l'ensemble formé par le chip 1 muni de son antenne 4 dans deux couches d'un matériau adapté. Pour ce faire, toutes les techniques connues sont applicables, qu'il s'agisse de laminage à froid ou à chaud de deux feuilles d'une matière fibreuse (textile ou papier) ou plastique, de collage à froid ou à chaud ou d'autres moyens permettant d'enfermer le chip 1 muni de son antenne 4 entre deux feuilles d'un matériau ad hoc.

Dans une variante, l'étiquette électronique est uniquement constituée du chip 1 muni de son antenne et peut être directement intégrée dans des objets divers comme des vêtements par exemple. Dans ce cas, il n'est pas nécessaire d'enfermer le chip muni de son antenne entre deux feuilles d'un matériau fibreux.

Dans une autre variante, le fil conducteur 4 destiné à former l'antenne de l'étiquette est enveloppé dans une gaine de fils textiles. Dans ce cas, le fil doit être dénudé sur une courte distance avant d'être soudé sur les plages de contact 2, 3 du chip 1.

Les étiquettes électroniques obtenues par ce procédé sont rapidement fabriquées en partie grâce à l'unicité de l'opération de soudage. Elles présentent par ailleurs une grande fiabilité, les risques de court-circuit entre les deux plages de contact étant réduits par rapport à d'autres techniques de fabrication.

## Revendications

1. Procédé de fabrication d'une étiquette électronique comprenant un chip électronique (1) muni de deux plages de contact (2, 3) et un fil conducteur (4) destiné à former une antenne, dans lequel :
- on dépose le chip électronique (1) sur un support de manière à ce que les plages de contact (2, 3) dudit chip soit situées du côté opposé à celui en contact avec le support,
- on déroule un fil conducteur (4) de manière à ce qu'au moins une partie de ce fil soit positionné en regard des deux plages de contact du chip électronique (1),
**caractérisé en ce que :**
- on soude le fil conducteur (4) sur les deux plages de contact (2, 3) en une seule opération de soudage,
- on coupe la partie du fil conducteur (4) située entre les deux plages de contact (2, 3) du chip (1).

2. Procédé de fabrication d'une étiquette électronique selon la revendication 1, **caractérisé par le fait que** la soudure du fil conducteur (4) sur les plages de contact (2, 3) est effectuée au moyen d'une électrode de soudage (5) présentant à l'extrémité de sa partie active un évidement (6) d'une largeur correspondant sensiblement à la distance comprise entre les deux plages de contact (2, 3).

3. Procédé de fabrication d'une étiquette électronique selon l'une des revendications précédentes, **caractérisé en ce que** le chip (1) muni de son antenne (4) est intégré entre deux feuilles d'un matériau fibreux ou plastique.

## Claims

1. Method for making an electronic label comprising an electronic chip (1) provided with two contact pads (2, 3) and a conducting wire (4) intended to form an antenna, wherein
- the electronic chip (1) is placed on a support in such a way that the contact pads (2, 3) of the chip are situated on the side opposite to that in touch with the support,
- a conducting wire (4) is uncoiled in such a way that at least a portion of this wire is positioned so as to face the two contact pads of the electronic chip (1),
**characterised in that**
- the conducting wire (4) is welded to the two contact pads (2, 3) in a single welding operation,
- the part of the conducting wire (4) situated between the two contact pads (2, 3) of the chip (1) is cut through.

2. Method for making an electronic label according to claim 1, **characterised in that** the welding of the conducting wire (4) to the contact pads (2, 3) is done with a welding electrode (5) which at the end of its active part has a recess (6) the width of which essentially corresponds to the distance between the two contact pads (2, 3).

3. Method for making an electronic label according to one of the preceding claims, **characterised in that** the chip (1) provided with its antenna (4) is integrated between two sheets of a fibre or plastic material.

## Patentansprüche

1. Verfahren zur Herstellung eines elektronischen Etiketts mit einem Elektronikchip (1), der mit zwei Kontaktpads (2, 3) versehen ist, und einem Leitungsdraht (4), der dafür bestimmt ist, eine Antenne zu bilden, worin
- der Elektronikchip (1) so auf einen Träger gelegt wird, dass sich die Kontaktpads (2, 3) des Chips auf der Seite befinden, die der Seite in Berührung mit dem Träger entgegengesetzt ist,
- ein Leitungsdraht (4) so abgewickelt wird, dass zumindest ein Abschnitt dieses Drahtes den beiden Kontaktpads des Elektronikchips (1) zugewandt ist,
**dadurch gekennzeichnet, dass**
- der Leitungsdraht (4) in einer einzigen Schweissoperation an die beiden Kontaktpads (2, 3) angeschweisst wird,
- der Abschnitt des Leitungsdrahts (4), der sich zwischen den beiden Kontaktpads (2, 3) des Chips (1) befindet, durchgeschnitten wird.

2. Verfahren zur Herstellung eines elektronischen Etiketts nach Anspruch 1, **dadurch gekennzeichnet, dass** das Aufschweissen des Leitungsdrahtes (4) auf die Kontaktpads (2, 3) mittels einer Schweisselektrode (5) ausgeführt wird, die am Ende ihres aktiven Teils eine Aussparung (6) aufweist, deren Breite im Wesentlichen dem Abstand zwischen den beiden Kontaktpads (2, 3) entspricht.

3. Verfahren zur Herstellung eines elektronischen Etiketts nach einem der vorangehenden Ansprüche, **dadurch gekennzeichnet, dass** der mit seiner Antenne (4) versehene Chip (1) zwischen zwei Folien eines Faser- oder Kunststoffmaterials integriert wird.
